# EUROPEAN PATENT SPECIFICATION

(11) **EP 3 213 349 B1**
(45) Date of publication and mention of the grant of the patent: **05.06.2019**
(21) Application number: 14868705.6
(22) Date of filing: 31.10.2014
(51) Int. Cl.: H01L 27/24, G11C 13/00

(54) **MEMORY APPARATUS AND METHOD OF PRODUCTION THEREOF**
SPEICHERVORRICHTUNG UND VERFAHREN ZU DEREN HERSTELLUNG
APPAREIL DE MÉMOIRE ET SON PROCÉDÉ DE FABRICATION

(43) Date of publication of application: 06.09.2017
(73) Proprietor: LytEn, Inc., Sunnyvale, CA 94086 (US)
(72) Inventor: BESSONOV, Alexander Alexandrovich, Moscow 117588 (RU); ASTLEY, Michael, Waterbeach CB25 9HP (GB)
(74) Representative: Mewburn Ellis LLP
(86) International application number: PCT/RU2014/000828
(87) International publication number: WO 2016/068745

(56) References cited:
- WO-A1-2013/162574
- WO-A2-2010/082923
- KR-A- 20120 068 598
- US-A1- 2014 027 702

## Description

### TECHNICAL FIELD

The present application relates to microelectronics. In particular, the present application relates to memory apparatuses.

### BACKGROUND OF THE INVENTION

Among a variety of alternative memory technologies, resistive random access memory (RRAM or ReRAM) has attracted considerable attention in recent years. RRAM is primarily based on electrically switchable resistance of metal oxides and chalcogenides supported by nanoionic transport processes and redox reactions. Other switching mechanisms involving pure physical processes such as electron/hole trapping have been intensively discussed.

Structural analogues of monolayer graphene such as transition metal dichalcogenides (TMD) and transition metal oxides (TMO) have attracted a lot of attention in recent years due to their unique electronic and optical properties. Their mechanical flexibility, transparency and compatibility with solution-processable technologies have been of high interest.

WO 2013/162574 A1 describes a customizable nonlinear electrical device including a first conductive layer, a second conductive layer, and a thin film metal-oxide layer sandwiched between the first conductive layer and the second conductive layer to form a first rectifying interface between the metal-oxide layer and the first conductive layer and a second rectifying interface between the metal-oxide layer and the second conductive layer.

WO 2010/082923 A2 describes a configurable memristive device for regulating an electrical signal including a memristive matrix containing a first dopant species; emitter, collector, and a base electrodes which are in contact with the memristive matrix; and a mobile dopant species contained within a central region contiguous with the base electrodes, the mobile dopant species moving within the memristive matrix in response to a programming electrical field. A method of configuring and using a memristive device includes: applying a programming electrical field across a memristive matrix such that a mobile dopant species creates a central doped region which bisects the memristive matrix; and applying a control voltage to the central doped region to regulate current flow between an emitter electrode and a collector electrode.

US 2014/027702 A1 describes a vertically integrated reconfigurable and programmable diode/memory resistor and thin film transistor/memory resistor structures built on substrates.

KR 2012/0068598 A describes a substrate barrier dielectric layer reducing the mechanical stress of a substrate.

### SUMMARY

In this section, the main embodiments of the present invention as defined in the claims are described and certain definitions are given. In accordance with the present invention there are provided a device and a method according to the independent claims 1 and 10.

According to an aspect of the present invention, an apparatus is disclosed. The apparatus comprises: a resistive memory component comprising an active material and two or more electrodes in electrical contact with the active material of the resistive memory component; and a selector component providing control over the resistive memory component, the selector component comprising an active material and two or more electrodes in electrical contact with the active material of the selector component. In this aspect, the resistive memory component and the selector component share one or more electrodes, and the resistive memory component and the selector component share at least part of the active material.

The apparatus may be, for example, a memory apparatus, a resistive non-volatile memory apparatus or an apparatus with combined memory and selector.

The active material of the resistive memory component and the selector component may be substantially the same. Alternatively, the mentioned components may share only part of the active material.

According to an embodiment, the resistive memory component comprises a memristor.

The memristor is an electrical resistance switch with the capability to retain a state of resistance based on the history of applied voltage and passed charge. According to an embodiment, the memristor may be a two-terminal vertical-stack, two-terminal planar or three-terminal resistance switch. The memristor may include chemical and/or physical switching mechanisms.

According to an embodiment of the present invention, the abovementioned memristor is a bipolar, unipolar or irreversible memristor.

According to an embodiment, the selector component comprises a diode. By diode is meant a two-terminal component with asymmetric conductance.

According to an embodiment, the diode is selected from a Schottky diode and a p-n diode. Operation of a Shottky diode is based on a metal-semiconductor junction, while operation of a p-n diode is based on a p-n junction.

According to an embodiment, the selector component comprises a transistor.

According to an embodiment, the transistor is a top-gate transistor comprising a source electrode, a gate electrode and a drain electrode. In other words, the transistor comprises source, gate and drain terminals which include electrodes. The selector component can share the drain electrode or the source electrode with the resistive memory component. In an embodiment, the transistor may also be a bottom gate transistor.

According to an embodiment, one electrode of the resistive memory component and at least one electrode of the selector component are connected to a common electrical circuit. The connection may be in series or in parallel.

According to an embodiment, the active material of the resistive memory component and/or the active material of the selector component comprises one or more materials selected from the group of: transition metal dichalcogenides (TMD), partially oxidized TMD, transition metal oxides (TMO) and graphene-like materials.

In an embodiment, part of the active material of the resistive memory component that is in proximity to one of the electrodes of the resistive memory component is fully oxidized, and the remaining active material of the resistive memory component is partially oxidized or unoxidized.

Part of the active material in proximity to an electrode can refer to any part of the active material that is closer than 100 nm to the electrode.

According to an embodiment, elements of the resistive memory component are arranged to form a vertical stack. By vertical stack is meant a structure which comprises a bottom electrode, an active material positioned on top of the bottom electrode, and a top electrode positioned on top of the active material. In an embodiment, the resistive memory component having a vertical stack structure shares the bottom electrode with the selector component.

The apparatus according to any of the abovementioned embodiments may be used as a memory cell. For example, the apparatus may be used as a resistive non-volatile memory cell which is combined with a selector.

The apparatus according to any of the abovementioned embodiments may be used in a resistive switching memory array.

According to an embodiment, all of the electrodes comprise at least one conductive material from the group of: metals, metal oxides, carbon-based materials, organic materials and polymer materials. The electrodes may comprise metals selected from the group of: silver, gold, copper, aluminum, nickel and cobalt, but not limited to these.

According to an aspect of the present invention, a method is disclosed. The method comprises: providing a substrate; depositing on the substrate one or more bottom electrodes; depositing over the one or more bottom electrodes an active material comprising a transition metal dichalcogenide, transition metal oxide, or their heterostructure or hybrid; modifying part of the active material; and depositing a top electrode on the modified part of the active material.

The method may be, but not limited to, a method for producing or fabricating a memory apparatus, or a method for producing or fabricating a memory cell combined with a selector.

In an alternative embodiment, the one or more bottom electrodes may be embedded into the provided substrate instead of the deposition.

As it is clear to a skilled person, the bottom and top electrodes are named accordingly only for clarity purposes. The method is not limited to the described order of deposition and modification of the materials.

In an embodiment, the method further comprises depositing on the active material an insulating material.

According to an embodiment, the method further comprises depositing on the active material a second top electrode. The second top electrode may be deposited on the area of the active material which was not modified. In an embodiment, the second electrode may be deposited on the insulating material.

According to an embodiment, modifying part of the active material comprises partially or fully oxidizing said part of the active material. In an embodiment, partially or fully oxidizing part of the active material comprises treating part of the active material in an environment comprising oxygen or ozone by at least one of the following techniques: local convection heating, IR heating, laser, plasma, and xenon flash lamp treatment.

According to an embodiment, modifying part of the active material comprises depositing on said part of the active material a transition metal oxide (TMO) from a nanoflake solution.

According to an embodiment, the bottom and top electrodes are deposited by at least one of the following deposition techniques: printing, sputtering, photolithography, chemical vapor deposition, atomic layer deposition and physical vapor deposition. Printing of the electrodes may include, for example, spin-coating, slot-die coating, spray coating, soft lithography, transfer printing, laser patterning, dispensing, screen printing, offset printing, gravure printing, flexography, aerosol jet printing, and inkjet printing.

According to an embodiment, the active material is deposited over the two or more bottom electrodes from a nanoflake solution by at least one of the following deposition techniques: slot-die coating, spray coating, spreading technique, and inkjet printing.

As it is clear to a skilled person, the methods according to these embodiments are not limited to the mentioned techniques, and they are indicated for exemplary purposes only.

According to a third aspect of the present invention, an apparatus is disclosed. The apparatus comprises: at least one processor; at least one memory coupled to the at least one processor, the at least one memory comprising program code instructions which, when executed by the at least one processor, cause the apparatus to perform the methods according to any of the abovementioned embodiments.

According to a fourth aspect of the present invention, an apparatus is disclosed. The apparatus comprises: means for providing a substrate; means for depositing on the substrate one or more bottom electrodes; means for depositing over the one or more bottom electrodes an active material comprising a transition metal oxide-transition, transition metal dichalcogenide, or a heterostructure or hybrid comprising said materials; means for modifying part of the active material; and means for depositing a top electrode on the modified part of the active material.

### BRIEF DESCRIPTION OF THE DRAWINGS

For a more complete understanding of example embodiments of the present invention, reference is now made to the following descriptions taken in connection with the accompanying drawings in which:
FIGURES 1a to 1c show apparatuses according to embodiments;
FIGURES 2a and 2b are schematics of memory arrays according to embodiments; and
FIGURE 3 shows a method according to an embodiment.

### DETAILED DESCRIPTON OF THE EMBODIMENTS

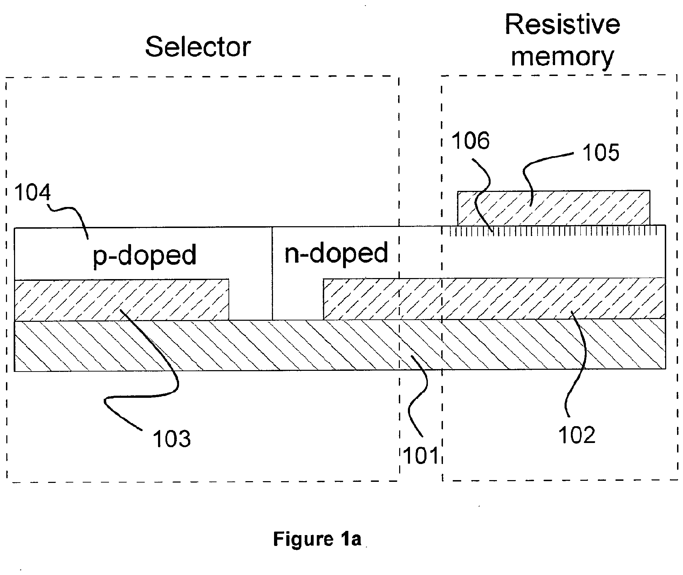

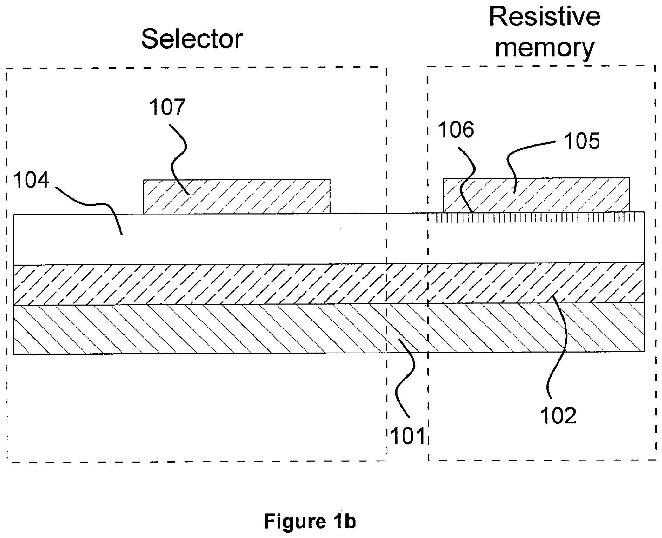

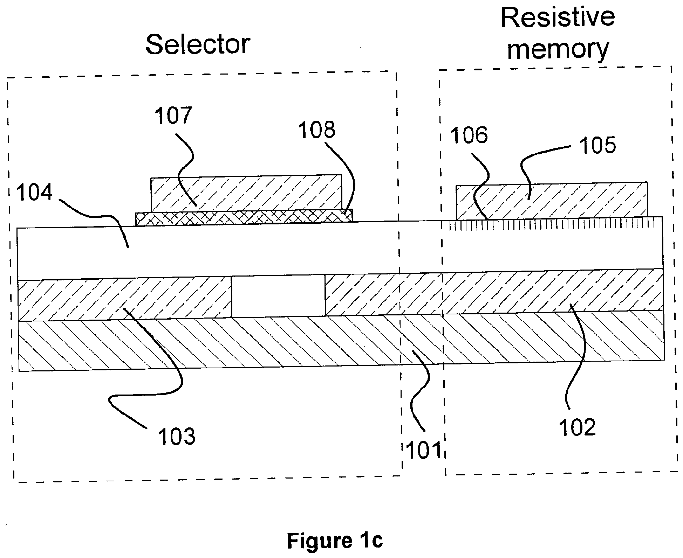

Exemplary embodiments of the present invention and its potential technical effects are understood by referring to Figures 1 through 3 of the drawings.

Embodiments of the present invention relate to a memory apparatus and its manufacturing method based on solution-processing of two-dimensional (2D) materials.

The apparatus comprises two components, a resistive memory component and a selector component, as shown on Figs. 1a-1c. In the examples shown in Figs. 1a-1c, the resistive memory component is a memristor which creates a resistive memory cell, while the selector component is a p-n diode (Fig.1a), a Schottky diode (Fig. 1b) or a transistor (Fig. 1c). It is clear to a skilled person that the configurations shown in these figures are examples of implementation of the present invention, and the claimed apparatus is not limited to the structures shown therein.

The apparatus may be a memory apparatus. In an embodiment, the apparatus can comprise a substrate 101 which can be made of any appropriate material such as glass, metal, polymer, silicone, rubber or other composite materials.

The apparatus comprises a first electrode 102 and optionally a second electrode 103, as shown in the configurations of Figs. 1a and 1c. The electrodes can comprise a conductive material, for example a metal. The first and second electrodes 102, 103 may be planar electrodes, wires or any other appropriate type of electrodes. In the embodiment, the first electrode 102 and the second electrode 103 may be referred to as "bottom electrodes" for clarity purposes only, and without limitations. The bottom electrodes 102, 103 may be separate from the substrate 101 or embedded into it.

The first electrode 102 is shared by the resistive memory and the selector components, while the second electrode 103 is an electrode of the selector. The apparatus further comprises active material 104 in electrical contact with the bottom electrodes 102, 103. The active material 104 can comprise, for example, materials such as transition metal dichalcogenides (TMD), partially oxidized TMD, transition metal oxides (TMO), TMD-TMO composites and other graphene-like materials. These materials may be two-dimensional (2D) layered materials such as single-layer or few-layer materials. The TMD materials may be selected from the group of materials with the following chemical formulas: WX₂, MoX₂, ScX₂, TiX₂, HfX₂, ZrX₂, VX₂, CrX₂, MnX₂, FeX₂, CoX₂, NiX₂, NbX2, TcX₂, ReX₂, PdX₂ and PtX₂ wherein "X" may be S, Se or Te. The TMO materials may be selected from the group of materials with the following chemical formulas: WOₙ, MoOₙ, ScOₙ, TiOₙ, HfOₙ, ZrOₙ, VOₙ, CrOₙ, MnOₙ, FeOₙ, CoOₙ, NiOₙ, NbOₙ, wherein "n" has a value of 2 or 3. The graphene-like materials may be selected from the group including graphene oxide and materials with the following chemical formulas: hexagonal BN, AlN, GaN, InN, InP, InAs, BP, BAs, GaP. All of the above materials may be provided as combinations of single-layer and/or few-layer flakes or other few-layer structures. As a result, the active material 104 may comprise one or more layered materials selected from the groups listed above.

For the purposes of this specification, the term "single-layer" refers to a 1 atomic layer (monolayer) whereas "few-layer" refers to a layered structure with 2-10 layers of atoms. It is clear to a skilled person that the active material 104 can comprise these materials in any combination, e.g. in homogenous composites or as separate hybrid layers, or in a heterostructure.

The active material 104 may be a common layer of material shared by the memory and selector component, or it may be shared only in part. Parts of the active material 104 may belong only to one of the components, for example the part that separates the bottom electrodes 102, 103 from each other and fills the space between them belongs to the selector. In Fig.1a, the selector is a p-n diode, and parts of the active material 104 are doped accordingly to create a p-n junction, as shown in Figure 1a. A p-n diode can also be formed by a type II heterojunction between different layered 2D materials (for example, WSe₂ and MoS₂).

The apparatus can also comprise one or more top electrodes 105 107, which are positioned on top of the active material 104 according to an exemplary embodiment. The top electrodes 105 107 can be in electrical contact with the active material 104. In Figs. 1a-1c there is a top electrode 105 which is an electrode of the resistive memory component, wherein the selector may not have a top electrode. Part 106 of the active material 104 that is in proximity to one of the electrodes (in the Figures the top electrode 105) may be modified. The modified active material 106 of the memory provides the effect of improved memristive properties. The part 106 can be modified, for example, by oxidation and/or addition of an oxide. The formed memristor is a bipolar memristor. However, unipolar or irreversible memristors can also be fabricated. The apparatus comprising an irreversible memristor can be used as part of a WORM (write one read many) memory.

Fig. 1b is an exemplary configuration with memristor as the resistive memory component and a Schottky diode as the selector component. In this configuration, there is one bottom electrode 102 which is shared by the components, and one additional top electrode 107. The Schottky diode can be formed by an electrode/semiconductor interface. Conductive metal oxides or metals with different work function potentials can be chosen as an electrode such that the Schottky barrier at the interface is maximized. Different electrodes may comprise the same material or different materials. Since a Schottky diode is formed from a metal-semiconductor junction rather than a p-n junction, it can provide the effect of increased switching speed.

Fig. 1c shows an example configuration where a memristor is used as the resistive memory component and a transistor is used as the selector. In this embodiment, two bottom electrodes 102, 103 and two top electrodes 105, 107 are used. The apparatus further comprises an insulator 108. The memristor and transistor share a common semiconducting layer of 2D material and one electrode. The resistive switching mechanism may rely on chemical processes involving electrically activated nanoionic transport or physical processes based on carrier charge trapping/detrapping. The transistor may be of a top-gate type; however, bottom-gate structures can also be applicable. The source and drain electrodes 103, 102 can be embedded into the substrate 101 or additively deposited. An active semiconductive material 104 can be a TMD with intrinsic charge transport, doped with native ion-deficiency dopants or extrinsic charged impurities, or doped with plasma-/heat-/light-assisted doping. The configuration of Fig. 1c can provide the technical effect of possibility of straight application of reverse currents to the memristor to program the apparatus.

According to an embodiment, at least one top electrode 105, 107 and at least one bottom electrode 102, 103 may be connected to the same electrical circuit. The components may be configured as series circuits or parallel circuits.

It is clear to a skilled person that the apparatus is not limited to the configurations as shown on Figs. 1a-1c, as long as one of the electrodes and at least a part of the active material is shared by the memory and selector components, providing the effect of a simple combined apparatus with memory functions. According to an embodiment, an array or stack of apparatuses according to the present invention is produced.

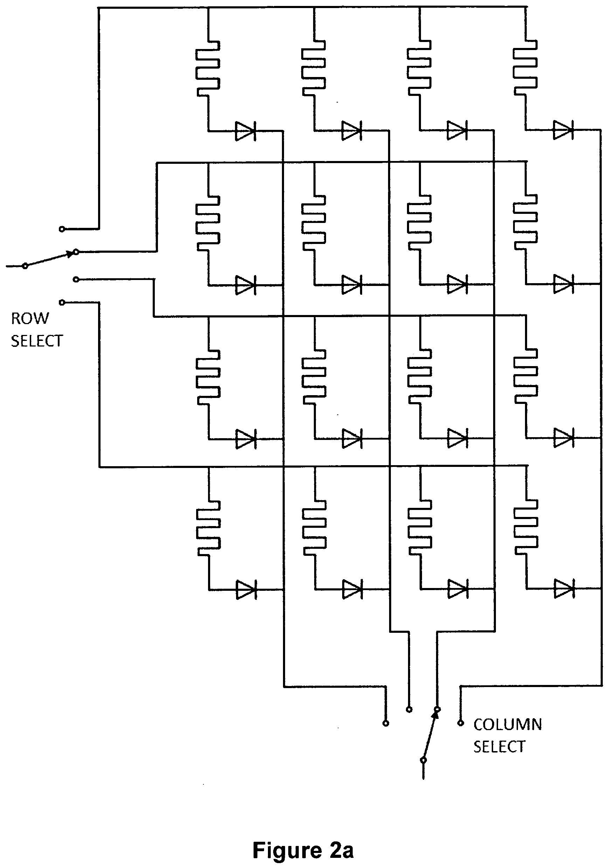

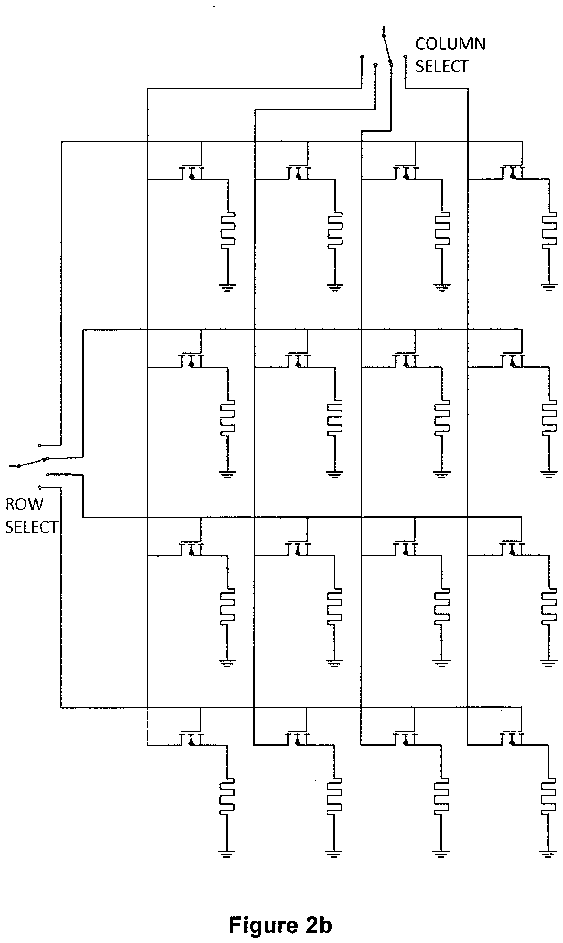

The apparatuses according to any of the above embodiments can be used as memory cells in crossbar arrays. Fig. 2a shows a schematic crossbar memory array with multiple rows and columns, wherein each memory cell comprises an apparatus according to an embodiment. Apparatuses on Fig. 2a each comprise one memristor as a memory component and one diode as a selector component. Fig. 2b shows a similar crossbar memory array with multiple rows and columns. In this embodiment, the apparatuses each comprise one memristor as a memory component and one transistor as a selector component.

Crossbar architecture with two-terminal cells can be useful in Resistive Random Access Memory (RRAM) data storage. Occurrence of a sneak path can be detrimental to reliable operation. The invention provides the technical effect of preventing a sneak path from occurring. According to embodiments, layered TMO/TMD heterostructures or TMO/TMD hybrids can be used as memory cells which exhibit a nonlinear I-V characteristic and self-rectifying functionality. A memristor physically combined with a selector, so that they share an active semiconductive layer and have common electrodes, provides the effect of simple manufacturing process requirements and reduced circuit complexity.

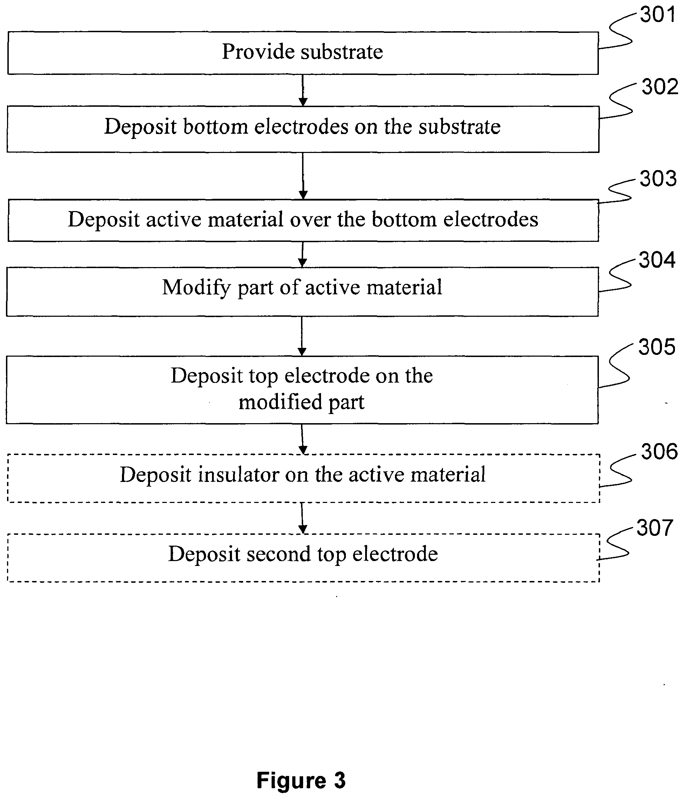

Fig. 3 shows a method according to an embodiment of the present invention. This method is suitable for production or fabrication of memory apparatuses such as the apparatus shown on Figs. 1a-1c. According to the method, a substrate can be provided at 301. The substrate may be conditioned before it is provided. The substrate may be rigid and for example made of glass or silicon, or comprise flexible foils such as glass, metal and plastic.

Bottom electrodes are then deposited onto the substrate at 302. In an exemplary embodiment, electrodes can be manufactured from metal nanoparticles or nanowires comprising silver, gold, copper, nickel, cobalt by printing technologies including screen printing, offset printing, gravure printing, flexography, aerosol jet printing, inkjet printing, but not limited to these. The printing may be followed by a sintering/curing step. Alternatively, vacuum techniques (sputtering, ALD, CVD, PVD) can be used. Other possible conductors such as metal oxides, carbon-based, organic materials and polymer composites can be used as electrodes.

In an embodiment, the electrodes may be embedded into the substrate and provided together with the substrate at 301, and then step 302 can be skipped.

An active material is deposited over the bottom electrodes at 303. The active material may be a transition metal dichalcogenide (TMD), a partially oxidized TMD, a transition metal oxide (TMO) or a graphene-like material. The active material may also be a hybrid or heterostructure comprising these materials. Deposition techniques include for example chemical vapor deposition, atomic layer deposition, physical vapor deposition, and deposition from a nanoflake solution by at least one of the following deposition techniques: spin-coating, slot-diecoating, spray coating, spreading technique, lifting technique, thin film transfer, modified Langmuir-Blodgett method, soft lithography, drop-casting, aerosol jet printing, and inkjet printing. Thickness of the deposited active material layer may vary from 1 nanometer to 1 micrometer. Deposition from a nanoflake solution can provide the technical effect of a simple and fast process, lower cost combined with high throughput of the deposition, as well as low processing temperatures. The solution-based deposition can also be easy to scale up and compatible with plastic foils and roll-to-roll (R2R) manufacturing.

Part of the active material is then modified at 304. In an embodiment, TMD, TMO, layered heterostructure or randomly mixed hybrid can be locally modified by natural heat-assisted oxidation in oxygen atmosphere (for example, air, oxygen or ozone). A stencil mask or photolithographic mask can be used in the case of photonic flash oxidation, laser treatment and plasma-assisted oxidation. Thickness of the oxide layers depends on the oxidation degree which is governed by the energy delivered to the surface and can vary from 1 to 20 nanometers.

Modifying the active material may also include doping of the material. The doping can be performed, for example, by plasma treatment (plasma-assisted doping) in a specific gas atmosphere, for example, using O₂, SF₆, H₂S, CHF₃, CF₄ and others. Alternatively, chemical doping, heat-assisted or light-assisted doping may be used. As a non-limiting example, the chemical doping may be supported by thiol chemistry.

Finally, a top electrode is printed on the modified part at 305, which can result in a vertical-stack memristor structure of a memory component. An insulator may be optionally deposited on the active material, as shown at 306. For example, the insulator may be deposited on a part of the active material which has not been modified. In an embodiment, an additional top electrode may be deposited, as shown at 307. The additional top electrode may be deposited on top of the insulator, which can result in a transistor structure of a selector component. If the insulator is not deposited, the second top electrode may be deposited on an area of the active layer which has not been modified.

An apparatus in accordance with the invention may include at least one processor in communication with a memory or memories. The processor may store, control, add and/or read information from the memory. The memory may comprise one or more computer programs which can be executed by the processor. The processor may also control the functioning of the apparatus. The processor may control other elements of the apparatus by effecting control signaling. The processor may, for example, be embodied as various means including circuitry, at least one processing core, one or more microprocessors with accompanying digital signal processor(s), one or more processor(s) without an accompanying digital signal processor, one or more coprocessors, one or more multi-core processors, one or more controllers, processing circuitry, one or more computers, various other processing elements including integrated circuits such as, for example, an application specific integrated circuit (ASIC), or field programmable gate array (FPGA), or some combination thereof. Signals sent and received by the processor may include any number of different wireline or wireless networking techniques.

The memory can include, for example, volatile memory, non-volatile memory, and/or the like. For example, volatile memory may include Random Access Memory (RAM), including dynamic and/or static RAM, on-chip or off-chip cache memory, and/or the like. Non-volatile memory, which may be embedded and/or removable, may include, for example, read-only memory, flash memory, magnetic storage apparatuses, for example, hard disks, floppy disk drives, magnetic tape, etc., optical disc drives and/or media, non-volatile random access memory (NVRAM), and/or the like. If desired, the different functions discussed herein may be performed in a different order and/or concurrently with each other. Furthermore, if desired, one or more of the above-described functions may be optional or may be combined.

The abovementioned embodiments can provide the technical effect of a simple manufacturing process, which is easy to scale up, and the process can be coupled to mass production. The process is also compatible with low-melting-point plastic substrates, flexible substrates and Roll to Roll manufacturing. The resulting apparatus has a reduced complexity due to a combined selector and memristor structure, and the active material can be well below 100 nm allowing high transparency. A wide range of suitable active materials allows for tunable functional characteristics of final apparatuses.

Using layered TMO/TMD heterostructures according to the above embodiments as a memory cell can provide the effect of a nonlinear I-V characteristic and self-rectifying functionality. At least partially sharing the active layer and at least one electrode can lead to simplified manufacturing process and reduced circuit complexity. The TMO/TMD memristive apparatuses can demonstrate a resistive switching performance with high ON/OFF ratios approaching 10⁶, multiple resistance states, and low operating voltages below 0.2 V, making these apparatuses power-efficient. The apparatuses according to the above embodiments can have retention times of more than 10⁴ s, a switching endurance of over 10⁴ cycles and a mechanical durability to maintain critical resistance states with over 10⁴ bending cycles.

Although various aspects of the invention are set out in the independent claims, other aspects of the invention comprise other combinations of features from the described embodiments and/or the dependent claims with the features of the independent claims, and not solely the combinations explicitly set out in the claims.

It is also noted herein that while the above describes example embodiments of the invention, these descriptions should not be viewed in a limiting sense. Rather, there are several variations and modifications which may be made without departing from the scope of the present invention as defined in the appended claims.

## Claims

1. An apparatus, comprising:
a resistive memory component comprising an active material (104) and two or more electrodes (102, 105) in electrical contact with the active material of the resistive memory component; and
a selector component providing control over the resistive memory component, the selector component comprising an active material (104) and two or more electrodes (102 or 103, 107) in electrical contact with the active material of the selector component, wherein
the resistive memory component and the selector component share one or more electrodes (102)
the resistive memory component and the selector component share at least part of the active material (104); **characterized in that**
part of the active material of the resistive memory component that is in proximity to one of the electrodes of the resistive memory component is fully oxidized, and wherein the remaining active material of the resistive memory component is partially oxidized or unoxidized.

2. The apparatus claim 1, wherein the resistive memory component comprises a memristor.

3. The apparatus of any one of claims 1 to 2, wherein the selector component comprises a transistor.

4. The apparatus of claim 3, wherein the transistor is a top-gate transistor comprising a source electrode, a gate electrode and a drain electrode; wherein the selector component shares the drain electrode or the source electrode with the resistive memory component.

5. The apparatus of any one of claims 1 to 4, wherein one electrode of the resistive memory component and at least one electrode of the selector component are connected to a common electrical circuit.

6. The apparatus of any one of claims 1 to 5, wherein the active material of the resistive memory component and/or the active material of the selector component comprises one or more materials selected from the group of: transition metal dichalcogenides, partially oxidized transitional metal dichalcogenides, transition metal oxides and graphene-like materials.

7. The apparatus of any one of claims 1 to 6, wherein the elements of the resistive memory component are arranged to form a vertical stack.

8. Use of the apparatus according to any one of claims 1 to 7 as a memory cell.

9. Use of the apparatus according to any one of claims 1 to 7 in a resistive switching memory array.

10. A method, comprising:
providing a substrate (101);
depositing on the substrate (101) one or more bottom electrodes (102, 103);
depositing over the one or more bottom electrodes an active material (104) comprising a transition metal dichalcogenide, transition metal oxide, a heterostructure or hybrid comprising said materials;
modifying part of the active material such that the part is fully oxidized and the remaining active material is partially oxidized or unoxidized; and
depositing a top electrode (105, 107) on the modified part of the active material.

11. The method of claim 10, further comprising depositing on the active material an insulating material.

12. The method of any one of claims 10 to 11, further comprising depositing on the active material a second top electrode.

13. The method of claim 10, wherein modifying part of the active material comprises depositing on said part of the active material a transition metal oxide from a nanoflake solution; and

## Patentansprüche

1. Vorrichtung, umfassend:
ein resistives Speicherelement, das ein Aktivmaterial (104) und zwei oder mehr Elektroden (102, 105) in elektrischem Kontakt mit dem Aktivmaterial des resistiven Speicherelements umfasst; und
ein Auswahlelement, das eine Steuerung des resistiven Speicherelements bereitstellt, wobei das Auswahlelement ein Aktivmaterial (104) und zwei oder mehr Elektroden (102 oder 103, 107) umfasst, die in elektrischem Kontakt mit dem Aktivmaterial des Auswahlelements stehen, wobei das resistive Speicherelement und das Auswahlelement eine oder mehrere Elektroden (102) gemeinsam haben;
wobei das resistive Speicherelement und das Auswahlelement sich zumindest einen Teil des Aktivmaterials (104) teilen;
**dadurch gekennzeichnet, dass** ein Teil des Aktivmaterials des resistiven Speicherelements, der sich in der Nähe einer der Elektroden des resistiven Speicherelements befindet, vollständig oxidiert ist, und wobei das restliche Aktivmaterial des resistiven Speicherelements teilweise oxidiert oder nicht oxidiert ist.

2. Vorrichtung nach Anspruch 1, wobei das resistive Speicherelement einen Memristor umfasst.

3. Vorrichtung nach einem der Ansprüche 1 bis 2, wobei das Auswahlelement einen Transistor umfasst.

4. Vorrichtung nach Anspruch 3, wobei der Transistor ein Top-Gate-Transistor ist, der eine Source-Elektrode, eine Gate-Elektrode und eine Drain-Elektrode umfasst;
wobei das Auswahlelement die Drain-Elektrode oder die Source-Elektrode mit dem resistiven Speicherelement teilt.

5. Vorrichtung nach einem der Ansprüche 1 bis 4, wobei eine Elektrode des resistiven Speicherelements und mindestens eine Elektrode des Auswahlelements an einen gemeinsamen elektrischen Schaltkreis angeschlossen sind.

6. Vorrichtung nach einem der Ansprüche 1 bis 5, wobei das Aktivmaterial des resistiven Speicherelements und/oder das Aktivmaterial des Auswahlelements ein oder mehrere Materialien umfasst, ausgewählt aus der folgenden Gruppe:
Übergangsmetalldichalcogenide, partiell oxidierte Übergangsmetalldichalcogenide, Übergangsmetalloxide und graphenartige Materialien.

7. Vorrichtung nach einem der Ansprüche 1 bis 6, wobei die Elemente des resistiven Speicherelements so angeordnet sind, dass sie einen vertikalen Stapel bilden.

8. Verwendung der Vorrichtung nach einem der Ansprüche 1 bis 7 als Speicherzelle.

9. Verwendung der Vorrichtung nach einem der Ansprüche 1 bis 7 in einer Widerstandsschaltspeichermatrix.

10. Verfahren, umfassend:
Bereitstellen eines Substrats (101);
Abscheiden einer oder mehrerer Bodenelektrode(n) (102, 103) auf dem Substrat (101);
Abscheiden eines Aktivmaterials (104), das ein Übergangsmetalldichalcogenid, ein Übergangsmetalloxid, eine Heterostruktur oder ein die genannten Materialien umfassendes Hybrid umfasst, über der einen oder den mehreren Bodenelektrode(n);
Modifizieren eines Teils des Aktivmaterials, so dass der Teil vollständig oxidiert wird und das restliche Aktivmaterial teilweise oxidiert oder nicht oxidiert wird; und
Abscheiden einer oberen Elektrode (105, 107) auf dem modifizierten Teil des Aktivmaterials.

11. Verfahren nach Anspruch 10, ferner umfassend das Abscheiden eines isolierenden Materials auf dem Aktivmaterial.

12. Verfahren nach einem der Ansprüche 10 bis 11, ferner umfassend das Abscheiden einer zweiten oberen Elektrode auf dem Aktivmaterial.

13. Verfahren nach Anspruch 10, wobei das Modifizieren eines Teils des Aktivmaterials das Abscheiden eines Übergangsmetalloxids aus einer Nanoflake-Lösung auf diesem Teil des Aktivmaterials umfasst; und

## Revendications

1. Appareil, comprenant :
un composant de mémoire résistive comprenant un matériau actif (104) et deux électrodes ou plus (102, 105) en contact électrique avec le matériau actif du composant de mémoire résistive ; et
un composant sélecteur fournissant une commande sur le composant de mémoire résistive, le composant sélecteur comprenant un matériau actif (104) et deux électrodes ou plus (102 ou 103, 107) en contact électrique avec le matériau actif du composant sélecteur,
le composant de mémoire résistive et le composant sélecteur partageant une ou plusieurs électrodes (102) ;
le composant de mémoire résistive et le composant sélecteur partageant au moins une partie du matériau actif (104) ; **caractérisé en ce que**
une partie du matériau actif du composant de mémoire résistive qui se trouve à proximité de l'une des électrodes du composant de mémoire résistive est entièrement oxydée, et le matériau actif restant du composant de mémoire résistive étant partiellement oxydé ou non oxydé.

2. Appareil selon la revendication 1, dans lequel le composant de mémoire résistive comprend une memristance.

3. Appareil selon l'une quelconque des revendications 1 à 2, dans lequel le composant sélecteur comprend un transistor.

4. Appareil selon la revendication 3, dans lequel le transistor est un transistor à grille supérieure comprenant une électrode de source, une électrode de grille et une électrode de drain ; le composant sélecteur partageant l'électrode de drain ou l'électrode de source avec le composant de mémoire résistive.

5. Appareil selon l'une quelconque des revendications 1 à 4, dans lequel une électrode du composant de mémoire résistive et au moins une électrode du composant sélecteur sont raccordées à un circuit électrique commun.

6. Appareil selon l'une quelconque des revendications 1 à 5, dans lequel le matériau actif du composant de mémoire résistive et/ou du matériau actif comprend un ou plusieurs matériaux choisis dans le groupe : de dichalcogénures de métal de transition, de dichalcogénures de métal de transition partiellement oxydés, d'oxydes de métal de transition et de matériaux de type graphène.

7. Appareil selon l'une quelconque des revendications 1 à 6, dans lequel les éléments du composant de mémoire résistive sont agencés pour former une pile verticale.

8. Utilisation de l'appareil selon l'une quelconque des revendications 1 à 7 en tant que cellule de mémoire.

9. Utilisation de l'appareil selon l'une quelconque des revendications 1 à 7 dans une matrice de mémoire à commutation résistive.

10. Procédé, comprenant :
la fourniture d'un substrat (101) ;
le dépôt, sur le substrat (101), d'une ou de plusieurs électrodes inférieures (102, 103) ;
le dépôt, sur les une ou plusieurs électrodes inférieures, d'un matériau actif (104) comprenant un dichalcogénure de métal de transition, un oxyde de métal de transition, une hétérostructure ou un hybride comprenant lesdits matériaux ;
la modification d'une partie du matériau actif de sorte que la partie est entièrement oxydée et que le matériau actif restant est partiellement oxydé ou non oxydé ; et
le dépôt d'une électrode supérieure (105, 107) sur la partie modifiée du matériau actif.

11. Procédé selon la revendication 10, comprenant en outre le dépôt, sur le matériau actif, d'un matériau isolant.

12. Procédé selon l'une quelconque des revendications 10 à 11, comprenant en outre le dépôt, sur le matériau actif, d'une seconde électrode supérieure.

13. Procédé selon la revendication 10, dans lequel la modification de la partie du matériau actif comprend le dépôt, sur ladite partie du matériau actif, d'un oxyde de métal de transition à partir d'une solution nano-flocon, et
